# EUROPEAN PATENT APPLICATION

(11) **EP 4 478 848 A1**
(43) Date of publication of application: **18.12.2024**
(21) Application number: 22927385.9
(22) Date of filing: 16.02.2022
(51) Int. Cl.: H05K 5/03, H05K 5/00, H05K 7/14

(54) **DISPLAY DEVICE**

(71) Applicant: LG Electronics Inc., Yeongdeungpo-gu Seoul 07336 (KR)
(72) Inventor: KIM, Taegewn, Seoul 06772 (KR); LEE, Juhyun, Seoul 06772 (KR); KIM, Sangmin, Seoul 06772 (KR); KIM, Huisik, Seoul 06772 (KR); CHO, Jaewoo, Seoul 06772 (KR); KEUM, Kitae, Seoul 06772 (KR)
(74) Representative: Schornack, Oliver
(86) International application number: PCT/KR2022/002271
(87) International publication number: WO 2023/157985

(57) **Abstract**

Provided is a display device. A display device according to the present disclosure may include: a display panel; a frame positioned behind the display panel, and to which the display panel is coupled; and a back cover covering a rear of the frame, wherein the frame may include: a pin including a body protruding from a rear surface of the frame toward an inner side of the back cover and a head protruding from a side surface of the body toward an outer side of the body, and a portion of the back cover is located between the rear surface of the frame and the head and is hung on the head.

## Description

### [TECHNICAL FIELD]

The present disclosure relates to a display device.

### [BACKGROUND ART]

With the development of the information society, demand for display devices is growing in various forms, and in response to the demand, various display devices such as Liquid Crystal Display Device (LCD), Plasma Display Panel (PDP), Electro Luminescent Display (ELD), Vacuum Fluorescent Display (VFD), and Organic Light Emitting Diode (OLED) have been studied and used in recent years.

Among these, an LCD panel comprises a TFT substrate and a color substrate opposing each other with a liquid crystal layer between them and may display an image using the light emitted from a backlight unit. An OLED panel may display an image by depositing an organic material layer capable of self-emitting light on the substrate on which transparent electrodes are formed.

Recently, much research is being conducted on large-screen, ultra-thin display devices.

### [DETAILED DESCRIPTION OF INVENTION]

### [TECHNICAL PROBLEMS]

An object of the present disclosure is to solve the problem described above and other related problems.

Another object of the present disclosure may be to provide a structure capable of securing structural rigidity of a large-screen, ultra-thin display device.

Yet another object of the present disclosure may be to provide a display device capable of coupling a PCB and a back cover directly to a frame.

Still another object of the present disclosure may be to remove a plate for coupling a PCB and a back cover, thereby providing a display device with reduced weight and cost.

Yet still another object of the present disclosure may be to provide various examples of structures for coupling a PCB and a back cover to a frame.

### [TECHNICAL SOLUTION]

According to one aspect of the present disclosure for achieving the objects above or other objects, a display device may include: a display panel; a frame positioned behind the display panel and to which the display panel is coupled; and a back cover covering a rear of the frame, wherein the frame may include: a pin including a body protruding from the rear surface of the frame toward an inner side of the back cover and a head protruding from a side surface of the body toward an outer side of the body, and a portion of the back cover may be located between the rear surface of the frame and the head and may be hung on the head.

### [EFFECT OF INVENTION]

The effect of the display device according to the present disclosure is described as follows.

According to at least one of the embodiments of the present disclosure, it is possible to provide a structure capable of securing structural rigidity of a large-screen, ultra-thin display device.

According to at least one of the embodiments of the present disclosure, it is possible to provide a display device capable of coupling a PCB and a back cover directly to a frame.

According to at least one of the embodiments of the present disclosure, it is possible to remove a plat for coupling a PCB and a back cover, thereby providing a display device with reduced weight and cost.

According to at least one of the embodiments of the present disclosure, it is possible to provide various examples of structures for coupling a PCB and a back cover with a frame.

Further scope of applicability of the present disclosure will become apparent from the following detailed description. However, it should be understood that the detailed description and specific embodiments such as preferred embodiments of the present disclosure are given by way of illustration only, since various changes and modifications within the spirit and scope of the present disclosure may be clearly understood by those skilled in the art.

### [BRIEF DESCRIPTION OF THE DRAWING]

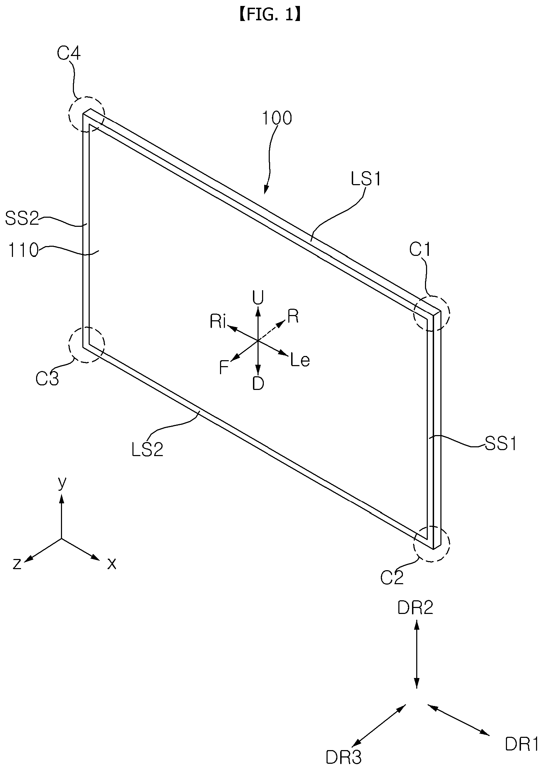

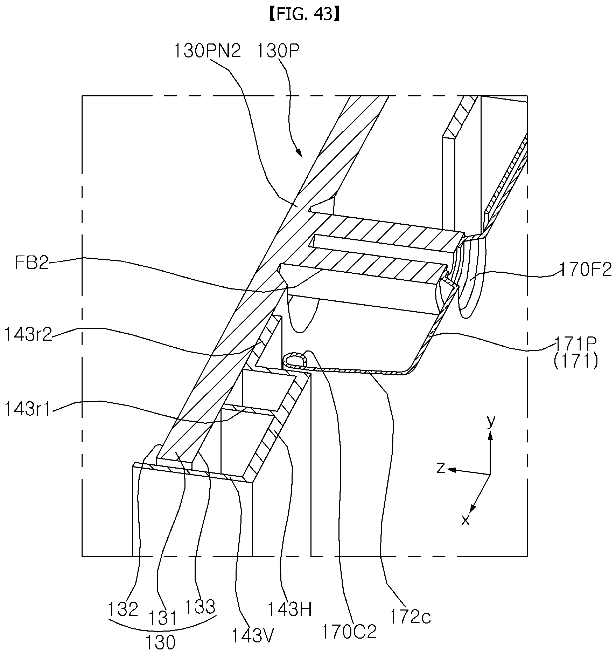

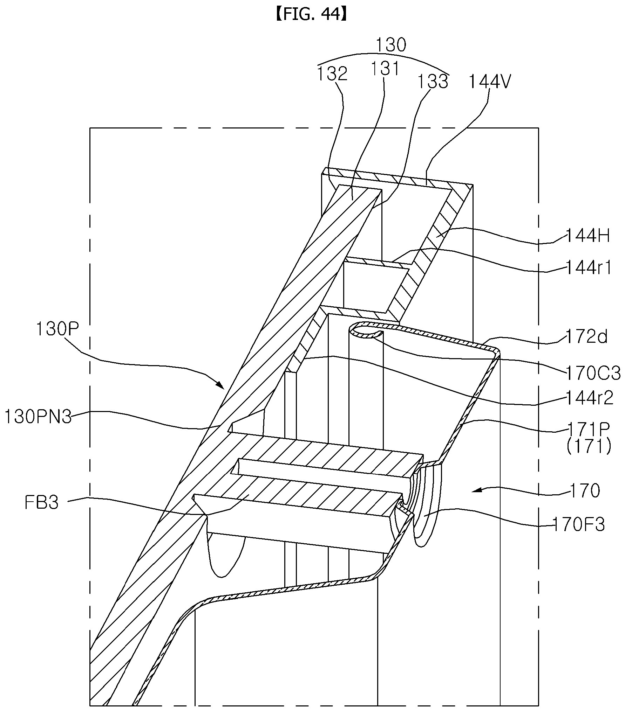

FIGS. 1 to 45 are diagrams illustrating examples of a display device according to embodiments of the present disclosure.

### [MODE FOR CARRYING OUT THE INVENTION]

In what follows, embodiments disclosed in this document will be described in detail with reference to appended drawings, where the same or similar constituting elements are given the same reference number irrespective of their drawing symbols, and repeated descriptions thereof will be omitted.

The suffixes "module" and "unit" for the constituting elements used in the following descriptions are assigned or used interchangeably only for the convenience of writing the present disclosure and do not have separate meanings or roles distinguished from each other.

Also, in describing an embodiment disclosed in the present document, if it is determined that a detailed description of a related art incorporated herein unnecessarily obscure the gist of the embodiment, the detailed description thereof will be omitted. Also, it should be understood that the appended drawings are intended only to help understand embodiments disclosed in the present document and do not limit the technical principles and scope of the present disclosure; rather, it should be understood that the appended drawings include all of the modifications, equivalents, or substitutes belonging to the technical principles and scope of the present disclosure.

Also, terms including an ordinal number such as first or second may be used to describe various constituting elements of the present disclosure, but the constituting elements should not be limited by these terms. Those terms are used only for the purpose of distinguishing one constituting element from the others.

If a constituting element is said to be "connected" or "attached" to other constituting element, the former may be connected or attached directly to the other constituting element, but there may be a case in which another constituting element is present between the two constituting elements. On the other hand, if a constituting element is said to be "directly connected" or "directly attached" to other constituting element, it should be understood that there is no other constituting element between the two constituting elements.

A singular expression should be understood to include a plural expression unless otherwise explicitly stated.

In the present disclosure, the term "include" or "have" is used to indicate existence of an embodied feature, number, step, operation, constituting element, component, or a combination thereof; and should not be understood to preclude the existence or possibility of adding one or more other features, numbers, steps, operations, constituting elements, components, or a combination thereof.

The indications of directions for up (U), down (D), left (Le), right (Ri), front (F), and rear (R) shown in the drawings are meant only for the convenience of descriptions and do not limit the technical principles and spirit of the present disclosure.

Referring to FIG. 1, a display device 100 may comprise a display panel 110. The display panel 110 may display a screen.

The display device 100 may include a first long side LS1, a second long side LS2 opposing the first long side LS1, a first short side SS1 adjacent to the first long side LS1 and the second long side LS2, and a second short side SS2 opposing the first short side SS1. Meanwhile, for the convenience of descriptions, it is assumed that the lengths of the first LS1 and second long side LS2 are longer than the lengths of the first SS1 and second short side SS2; however, it may also be possible that the lengths of the first and second long side LS1, LS2 are approximately the same as the lengths of the first and second short side SS1, SS2.

The direction parallel to the long sides LS1, LS2 of the display device 100 may be referred to as a first direction DR1 or left and right direction. The direction parallel to the short sides SS1, SS2 of the display device 100 may be referred to as a second direction DR2 or up and down direction. The direction perpendicular to the long sides LS1, LS2 and the short sides SS1, SS2 of the display device 100 may be referred to as a third direction DR3 or front and rear direction.

The direction along which the display device 100 displays an image may be referred to as front F, z, and the opposite direction thereof may be referred to as rear R. The first short side SS1 may be referred to as left side Le, x. The second short side SS2 may be referred to as right side Ri. The first long side LS1 may be referred to as up-side U, y. The second long side LS2 may be referred to as down-side D.

The first long side LS1, the second long side LS2, the first short side SS1, and the second short side SS2 may be referred to as an edge of the display device 100. In addition, the point at which the first long side LS1, the second long side LS2, the first short side SS1, and the second short side SS2 meet each other may be referred to as a corner.

The point at which the first short side SS1 and the first long side LS1 meet may be a first corner C1. The point at which the first short side SS1 and the second long side LS2 meet may be a second corner C2. The point at which the second short side SS2 and the second long side LS2 meet may be a third corner C3. The point at which the second short side SS2 and the first long side LS1 meet may be a fourth corner C4.

In what follows, a display panel using an organic light emitting diode (OLED) for the display panel 110 is described as an example, but the present disclosure is not limited to the specific display panel 110.

The display panel 110 may form a front surface of the display device 100 and may display an image to the front. The display panel 110 may divide the image into a plurality of pixels and output the image using color, brightness, and saturation values for each pixel. The display panel 110 may be divided into an active area where an image is displayed and a de-active area that does not display an image. The display panel 110 may generate light corresponding to red, green, or blue color according to a control signal.

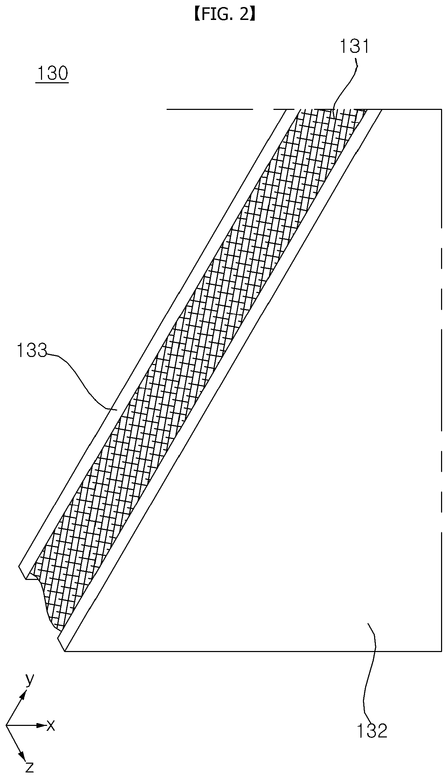

Referring to FIG. 2, a material complexed panel 130 may comprise a core 131, a front skin 132, and a rear skin 133. The core 131, front skin 132, and rear skin 133 may be coupled. The material complexed panel 130 may be referred to as a fiber complexed panel 130, a fiber complexed plate 130, a material complexed plate 130, or a frame 130.

The front skin 132 may form a front surface of the material complexed panel 130. The rear skin 133 may form a rear surface of the material complexed panel 130. The front skin 132 and the rear skin 133 may include a metallic material. For example, the front skin 132 and the rear skin 133 may include an aluminum (Al) material. For example, the thickness of the front skin 132 and the rear skin 133 may be about 0.5 mm. The front skin 132 and the rear skin 133 may be placed opposite each other with the core 131 between them.

The core 131 may be located between the front skin 132 and the rear skin 133. The core 131 may be have fibers. The core 131 may be made from a composite material. The core 131 may include a main fiber and a binder fiber. The binder fiber may be interwoven with the main fiber.

A hot-melt sheet may be located between the front skin 132 and the core 131. Also, the hot-melt seat may be located between the rear skin 133 and the core 131. The hot-melt sheet may be a film. For example, the hot-melt sheet may be a film such as EVA, acrylic, or polyurethane film having a thickness of 50 micrometers or more. The core 131 and the hot-melt sheet may be coupled with the front skin 132 and the rear skin 133 when heated at a high temperature (e.g., about 190 to 200 ° C) for more than one minute.

Accordingly, the material complexed panel 130 may improve the bending rigidity and/or torsional rigidity of the display device.

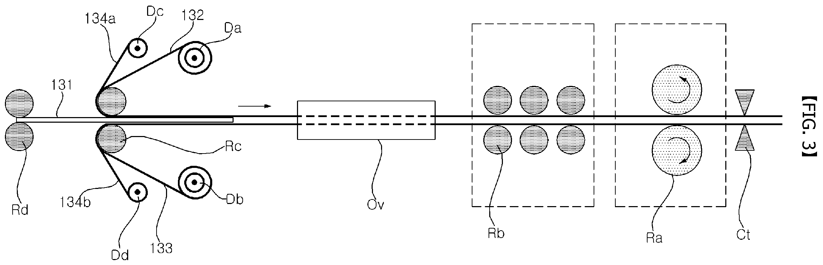

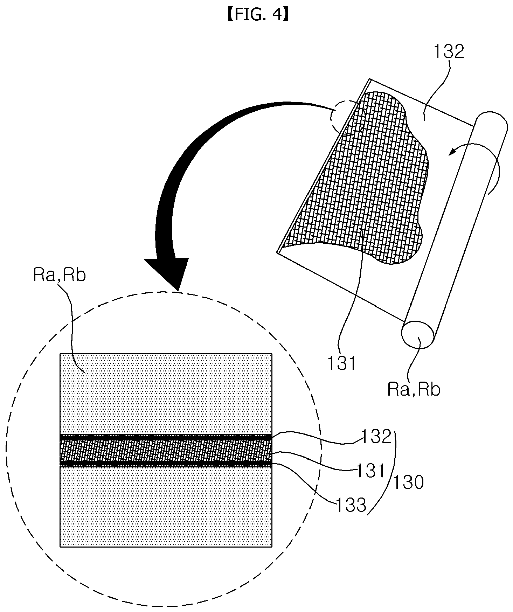

Referring to FIGS. 3 and 4, the material complexed panel 130 may be manufactured through a process of squeezing the front skin 132 and the rear skin 133 into the core 131 using a plurality of rollers, which may be referred to as a roll-to-roll (R2R) process.

Referring to FIG. 3, according to the rotation of a pinch roller Ra performing the function of a drive motor, the front skin 132 may be released from a front drum Da, the rear skin 133 may be released from a rear drum Db, and the core 131 may move through a feeding roller Rd. A first adhesive 134a for coupling the front skin 132 to the core 131 may be released from a first drum Dc. Also, a second adhesive 134b for coupling the rear skin 133 to the core 131 may be released from a second drum Db. In this case, the front skin 132, the first adhesive 134a, the core 131, the second adhesive 134b, and the rear skin 133 may be stacked in the order mentioned above and may be guided in the direction of an oven Ov by a guide roller Rc. The adhesives 134a, 134b may be hot-melt sheets 134a, 134b.

The first and second adhesives 134a, 134b may melt in the oven Ov, and the front skin 132 and the rear skin 133 may be coupled with the core 131. For example, the melting point of the first and second adhesives 134a, 134b may be about 150 °C, and the ambient temperature of the oven Ov may be about 200 ° C. For example, the peel-off force of the first and second adhesives 134a, 134b may be about 10 kgf or more.

The front skin 132, the core 131, and the rear skin 133 that have passed through the oven Ov may be guided to a squeezing roller Rb due to the rotation of a pinch roller Ra and may be squeezed by the squeezing roller Rb. Accordingly, a coupling force between the front skin 132, the core 131, and the rear skin 133 may be further increased. The front skin 132, the core 131, and the rear skin 133 coupled with each other may be cut by a cutter Ct after passing the pinch roller Ra to be fabricated into material complexed panels 130 of a predetermined size.

Referring to FIG. 4, the squeezing roller Rb or the pinch roller Ra may contact the outer surfaces of the front skin 132 and the rear skin 133. When the squeezing roller Rb or the pinch roller Ra rotates, the material complexed panel 130 may move in the longitudinal direction of the core 131. At this time, in the longitudinal direction of the core 131, the front skin 132 and the rear skin 133 may be coupled with the core 131 sequentially from one end to the other end of the core 131.

Also, the front skin 132 and the rear skin 133 of the material complexed panel 130 may be flat. In other words, as the rear surface of the rear skin 133 forming the rear surface of the display device 100 is formed to be flat, additional work of enhancing aesthetic appearance, such as painting the rear surface of the rear skin 133 or attaching sheet paper thereto may be easily performed. Alternatively, the flat rear skin 133 itself may form the rear surface of the display device 100.

Meanwhile, in addition to the R2R process described above with reference to FIGS. 3 and 4, the material complexed panel 130 may be fabricated through a process in which the front skin 132, the core 131, and the rear skin 133 are stacked in turn and then coupled with each other.

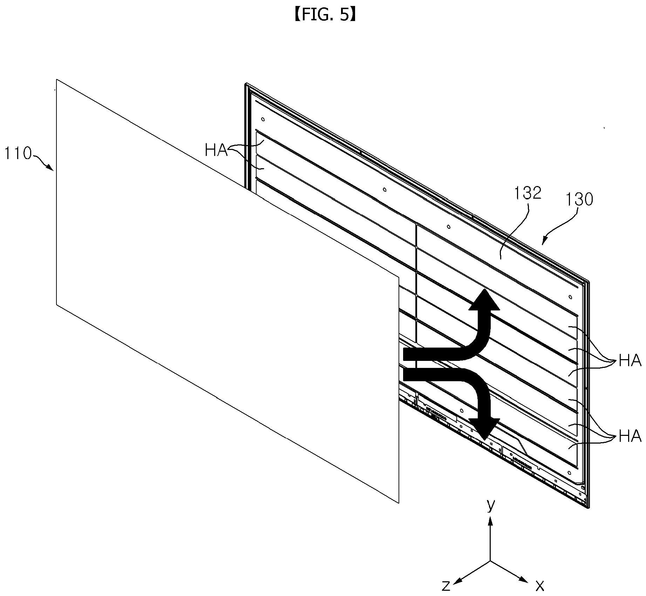

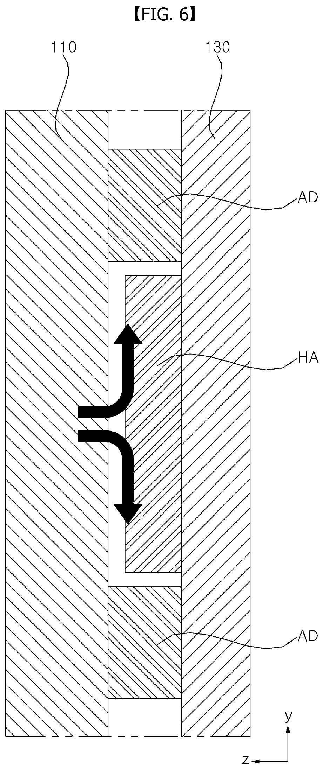

Referring to FIGS. 5 and 6, the display panel 110 may be bonded to the front skin 132 of the material complexed panel 130 by an adhesive member AD such as a double-sided tape. For example, the thickness of the adhesive member AD may be 0.2 to 0.4 mm.

A heatsink HA may be located in an air gap between the display panel 110 and the material complexed panel 130 and may be installed on the front skin 132. For example, a plurality of heatsinks HA may be installed on the front skin 132. The heatsink HA may include a metallic material. For example, the heatsink HA may be a plate or a tape made of aluminum (Al). For example, the thickness of the heatsink HA may be 0.15 to 0.25 mm, and the air gap between the display panel 110 and the material complexed panel 130 may be 0.04 to 0.1 mm.

Accordingly, the air gap between the display panel 110 and the material complexed panel 130 may be reduced by the heatsink HA, and the heat generated in the display panel 110 may be effectively removed.

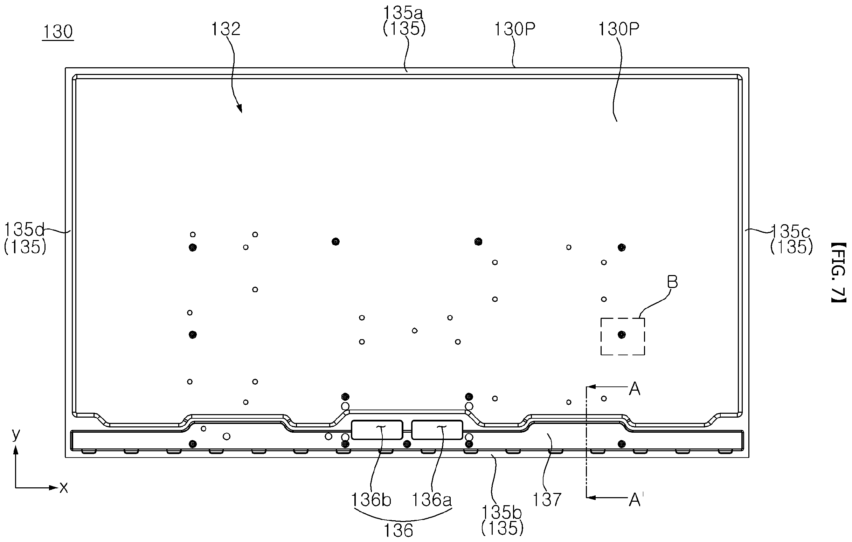

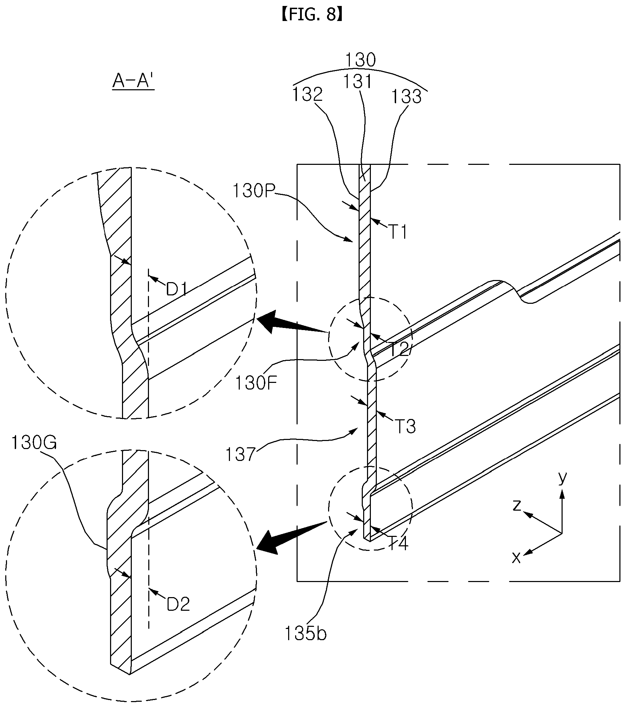

Referring to FIGS. 7 and 8, the material complexed panel 130 may include a flat portion 130P, a receiving portion 137, and an outer portion 135. The front skin 132 of the material complexed panel 130 may define the respective front surfaces of the flat portion 130P, the receiving portion 137, and the outer portion 135.

The outer portion 135 may be formed along the periphery of the flat portion 130P. The first outer portion 135a may be formed along the upper edge of the flat portion 130P. The second outer portion 135b may be formed along the lower edge of the flat portion 130P. The third outer portion 135c may be formed along the left edge of the flat portion 130P. The fourth outer portion 135d may be formed along the right edge of the flat portion 130P. The thickness T4 of the outer portion 135 may be less than the thickness T1 of the flat portion 130P.

The receiving portion 137 may be formed by being pressed to the rear from the flat portion 130P. The receiving portion 137 may be located between the lower edge of the flat portion 130P and the second outer portion 135b. The receiving portion 137 may form a step for the flat portion 130P and the second outer portion 135b. The thickness T3 of the receiving portion 137 may be greater than the thickness T4 of the outer portion 135.

The cable hole 136 may be formed through the receiving portion 137. For example, a plurality of cable holes 136a, 136b may be formed close to each other.

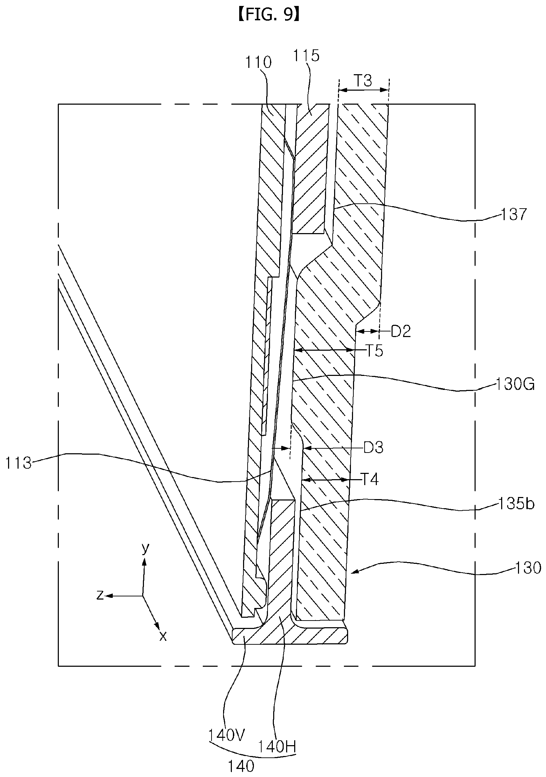

Referring to FIG. 9, the cable 113 may extend from the lower edge of the display panel 110 to between the display panel 110 and the material complexed panel 130.

A source PCB (S-PCB) 115 may be located in the receiving portion 137 of the material complexed panel 130. The S-PCB 115 may be electrically connected to the cable 113.

A side frame 140 may extend along the periphery of the display panel 110. The horizontal portion 140H may cover the side surface of the display panel 110 and the side surface of the material complexed panel 130. The vertical portion 140V may be located between the display panel 110 and the material complexed panel 130. The side frame 140 may be referred to as a guide panel or a middle cabinet.

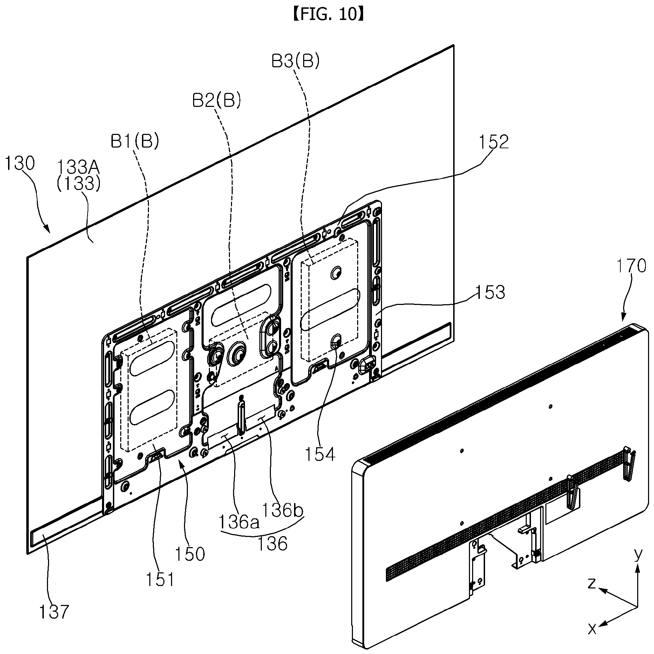

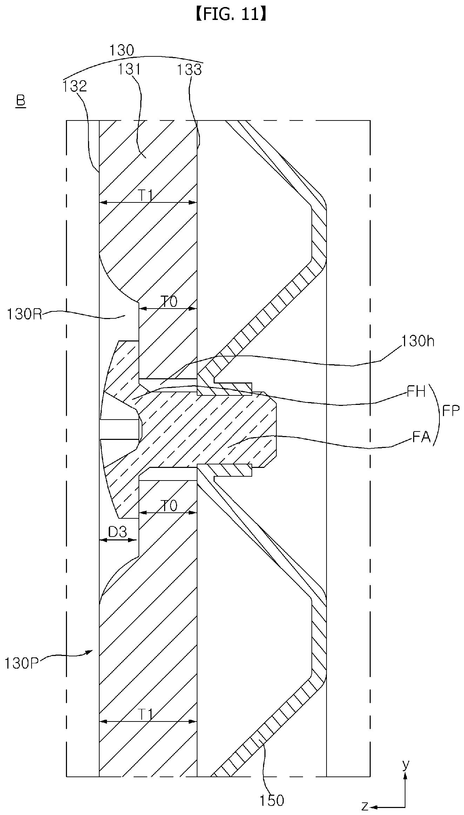

Referring to FIGS. 10 and 11, a coupling plate 150 may be located at the rear of the material complexed panel 130. The horizontal portion 152, the vertical portion 153, and the dome portion 154 of the coupling plate 150 may be formed by being pressed from the front to the rear of the body 151 of the coupling plate 150.

The body FA of a fastening member FP may penetrate a depression portion 130R, and the head FH of the fastening member FP may be hung on the front surface of the depression portion 130R. Here, the depression portion 130R may be formed by being depressed to the rear from the flat portion 130P. The body FA of the fastening member FP may be screwed into the coupling plate 150.

Accordingly, the coupling plate 150 may be coupled with the material complexed panel 130. The coupling plate 150 may be referred to as a PCB plate 150. A plurality of PCBs B1, B2, B3 may be mounted on the rear surface of the coupling plate 150.

A back cover 170 may cover the rear of the coupling plate 150. The back cover 170 may be coupled with the coupling plate 150 by screw coupling or another similar manner. A portion 133A of the rear skin 133 of the material complexed panel 130 may not be covered by the back cover 170.

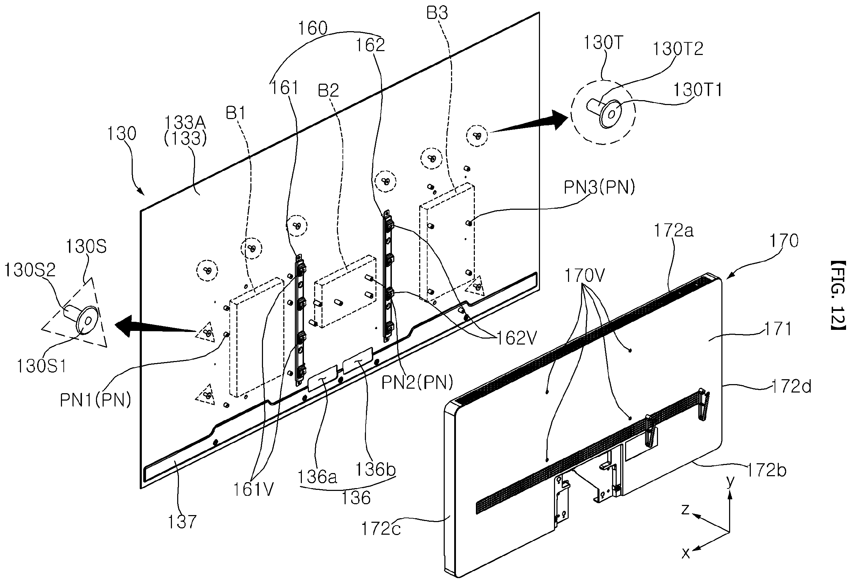

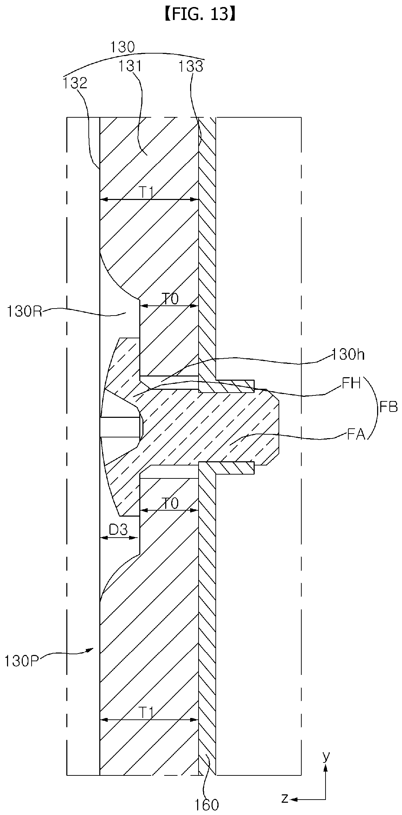

Referring to FIGS. 12 and 13, a vertical bar 160 may be extended in the vertical direction. The vertical bar 160 may be located at the rear of the material complexed panel 130. The first vertical bar 161 and the second vertical bar 162 may be separated from each other in the horizontal direction. The first vertical bar 161 and the second vertical bar 162 may have the same shape.

The body FA of a fastening member FB may penetrate the depression portion 130R, and the head FH of the fastening member FB may be hung on the front surface of the depression portion 130R. Here, the depression portion 130R may be formed by being depressed to the rear from the flat portion 130P. The body FA of the fastening member FB may be screwed into the vertical bar 160.

Accordingly, the first vertical bar 161 and the second vertical bar 162 may be coupled with the material complexed plate 130.

On the other hand, first fastening portions 161v may be formed on the first vertical bar 161 and may be separated from each other in the longitudinal direction of the first vertical bar 161. Second fastening portions 162v may be formed on the second vertical bar 162 and may be separated from each other in the longitudinal direction of the second vertical bar 162. The first fastening portions 161v and the second fastening portions 162v may be aligned with the fastening holes 170v formed on the back cover 170. The spacing between the fastening holes 170v may conform to the Video Electronics Standards Association (VESA) specifications.

Accordingly, stands or brackets for the display device may be screwed to the fastening portions 161v, 162v through the fastening holes 170v.

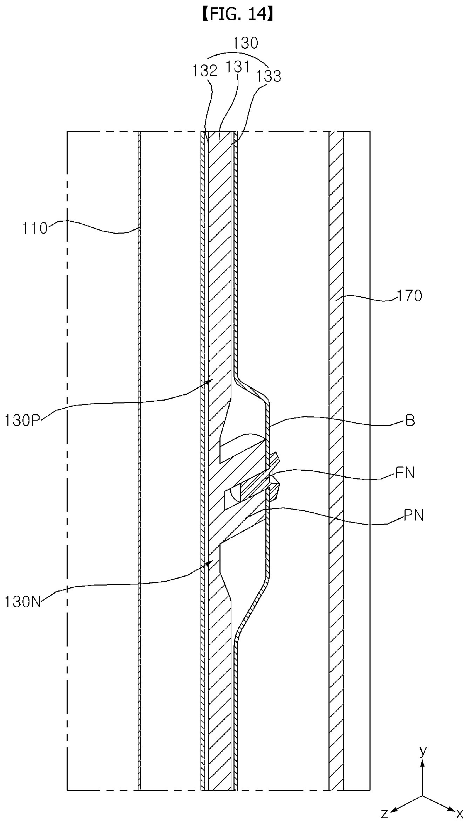

Referring to FIGS. 12 and 14, a printed circuit board (PCB) may be located at the rear of the material complexed panel 130. For example, a plurality of PCBs B1, B2, B3 may be spaced apart from each other. A power supply board B1 may provide power to each element of the display device. A timing controller (T-CON) board B2 may provide a video signal to the display panel 110. A main board B3 may control each configuration of the display device.

A fixing portion PN may protrude from the rear surface of the material complexed panel 130 to the rear. For example, the depression portion 130N may be formed by being depressed from the rear surface of the material complexed panel 130 to the front, and the fixing portion PN may protrude to the rear from the depression portion 130N. For example, the fixing portion PN may be a pem nut. A fastening member FN such as a screw may be fastened to the fixing portion PN through the PCB B.

Accordingly, the PCB B may be coupled with the material complexed panel 130. In other words, the PCB B may be coupled with the material complexed panel 130 without involving a PCB plate 150 (refer to FIGS. 10 and 11).

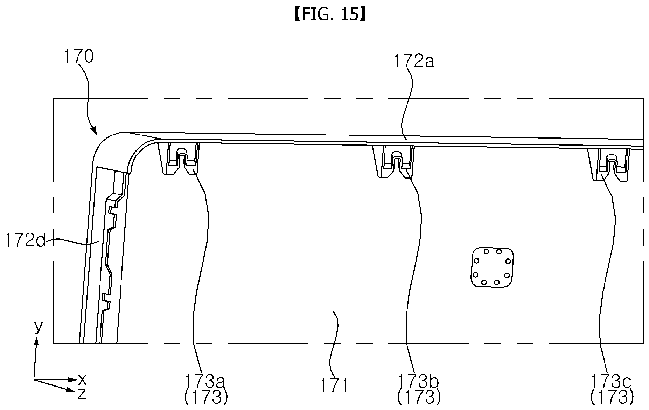

Referring to FIGS. 12 and 15, the back cover 170 may have a box shape opened to the front as a whole. The rear part 171 may form the rear surface of the back cover 170. The top part 172a may extend along the upper edge of the rear part 171 and may intersect the rear part 171. The bottom part 172b may extend along the lower edge of the rear part 171 and may intersect the rear part 171. The first side part 172c may extend along the left edge of the rear part 171 and may intersect the rear part 171. The second side part 172d may extend along the right edge of the rear part 171 and may intersect the rear part 171.

A hanging portion 173 may protrude from the inner side to the lower side of the top part 172a. A plurality of hanging portions 173a, 173b, and 173c may be spaced apart from each other along the top part 172 a. The hanging portions 173a, 173b, and 173c may have the same shape. The hanging portion 173 may be referred to as a latch.

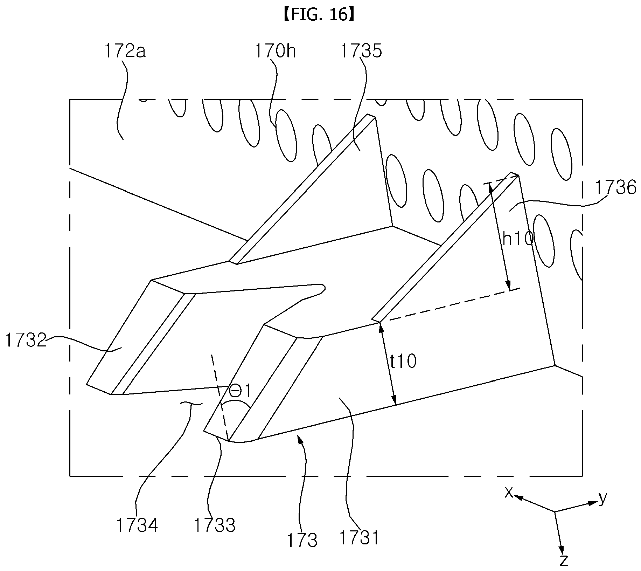

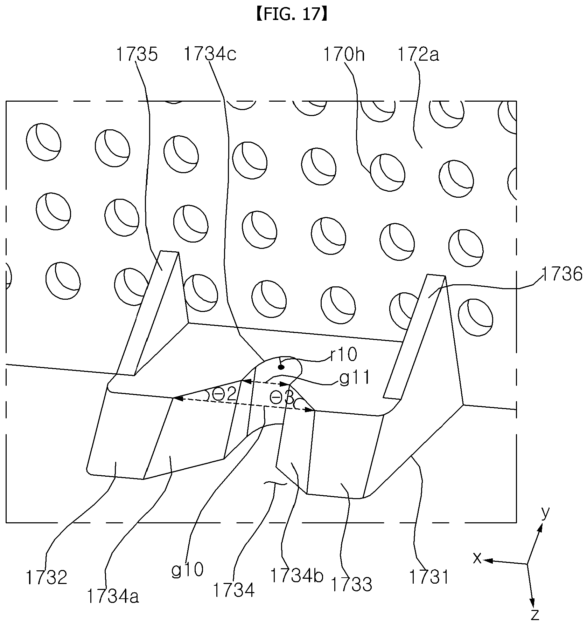

Referring to FIGS. 16 and 17, a block 1731 of the hanging portion 173 may extend in the direction of intersecting the top part 172a, and the upper end of the block 1731 may be fixed to the inner side of the top part 172a. For example, the block 1731 may be coupled with the top part 172a to form one body.

A rib 1735, 1736 may connect the rear surface of the block 1731 and the inner side of the top part 172a. The rib 1735, 1736 may have a triangular cross section, and the height h10 of the rib 1735, 1736 may be equal to or greater than the thickness t10 of the block 1731. The first rib 1735 may be adjacent to the left edge of the block 1731, and the second rib 1736 may be adjacent to the right edge of the block 1731. For example, the rib 1735, 1736 may be coupled with the top part 172a to form one body. Accordingly, the rib 1735, 1736 may enhance the stiffness of the block 1731.

A groove 1734 may be formed by being depressed from the lower edge of the block 1731 to the upper side. The first portion 1732 of the block 1731 may oppose the second portion 1733 of the block 1731 relative to the groove 1734, and the first portion 1732 and the second portion 1733 may form the lower edge of the block 1731. For example, the lower edge of the block 1731 may form a predetermined angle *θ*₁ with respect to a virtual line parallel to the forward and backward directions.

The first guide surface 1734a, the second guide surface 1734b, and the seating surface 1734c may define the boundary of the groove 1734. The first guide surface 1734a and the second guide surface 1734b may define the lower part of the boundary of the groove 1734, and the seating surface 1734c may define the upper boundary of the groove 1734.

The first guide surface 1734a may form a second angle *θ*₂ with respect to a virtual line parallel to the width direction of the groove 1734. The second guide surface 1734b may oppose the first guide surface 1734a with respect to the groove 1734 and may form a third angle *θ*₃ relative to a virtual line parallel to the width direction of the groove 1734. For example, the second angle *θ*₂ and the third angle *θ*₃ may be the same. In addition, the gap between the first guide surface 1734a and the second guide surface 1734c may gradually increase as the groove 1734 is traversed from top to bottom (note that g11 < g10 in FIG. 17). The guide surface 1734a, 1734b may be referred to as a chamfer.

The seating surface 1734c may connect the first guide surface 1734a to the second guide surface 1734b. The seating surface 1734c may be a convex surface. The seating surface 1734c may define the minimum width of the groove 1734.

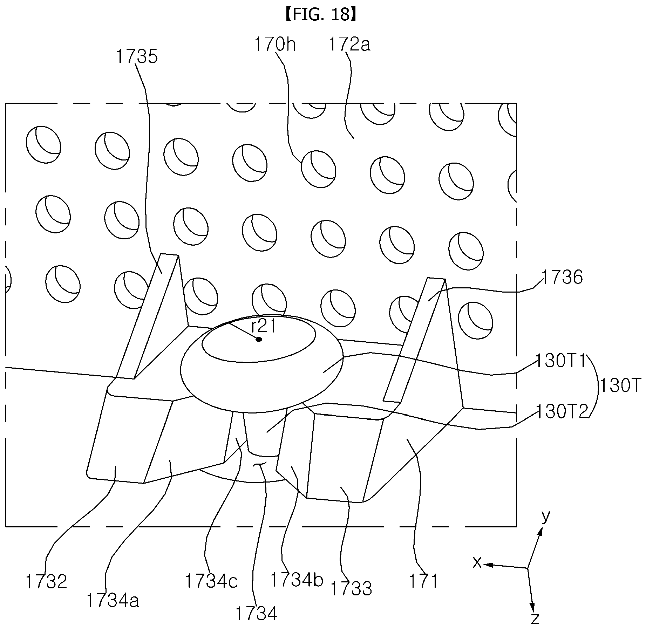

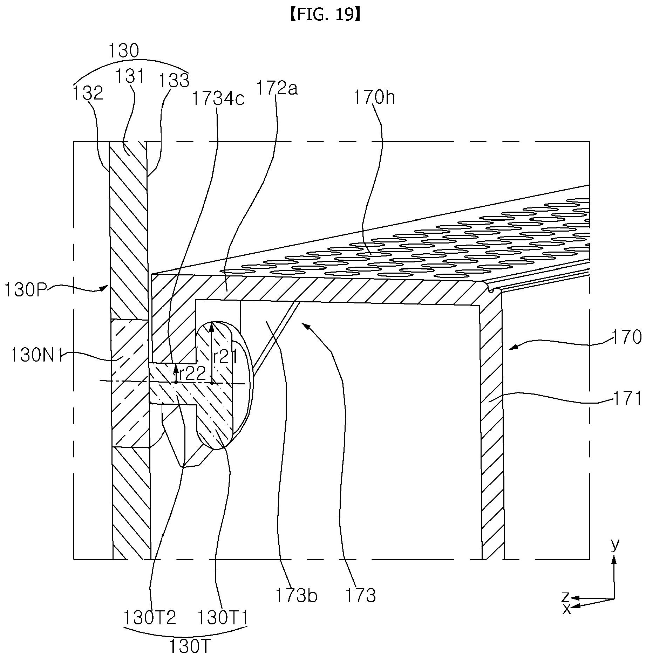

Referring to FIGS. 18 and 19, a top pin 130T may protrude from the rear surface to the rear of the material complexed panel 130. For example, the top pin 130T may be a pem nut provided in a portion 130N1 of the material complexed panel 130.

In addition, the top pin 130T may include a head 130T1 and a body 130T2. The body 130T2 may connect the material complexed panel 130 and the head 130T1. The radius r21 of the head 130T1 may be larger than the radius r22 of the body 130T2. In other words, an undercut may be formed between the head 130T1 and the body 130T2. Also, the periphery of the head 130T1 may be round-shaped.

In addition, the top pin 130T may be placed adjacent to the inner side of the top part 172a of the back cover 170. For example, a plurality of top pins 130T (refer to FIG. 12) may be spaced apart from each other along the top part 172a. The plurality of top pins 130T may be aligned with a plurality of hanging portions 173 (refer to FIG. 15).

The front surface of the block 1731 may be flat, and the hanging portion 173 may move smoothly on the rear skin 133 of the material complexed panel 130. In response to the movement of the hanging portion 173, the top pin 130T may be easily inserted into the groove 1734 of the hanging portion 173 along the guide surfaces 1734a, 1734b. In addition, as the periphery of the head 130T1 is round-shaped, the top pin 130T may be more easily inserted into the groove 1734.

The seating surface 1734c may be seated in the body 130T2, and the rear surface of the block 1731 may be hung on the head 130T1. In other words, the radius of curvature r10 (refer to FIG. 17) of the seating surface 1734c may be equal to or greater than the radius r22 of the body 130T2 and may be smaller than the radius r21 of the head 130T1.

Accordingly, the back cover 170 may be coupled with the material complexed panel 130 through the hanging portion 173. In other words, the back cover 170 may be coupled with the material complexed panel 130 without involving a PCB plate 150 (refer to FIGS. 10 and 11).

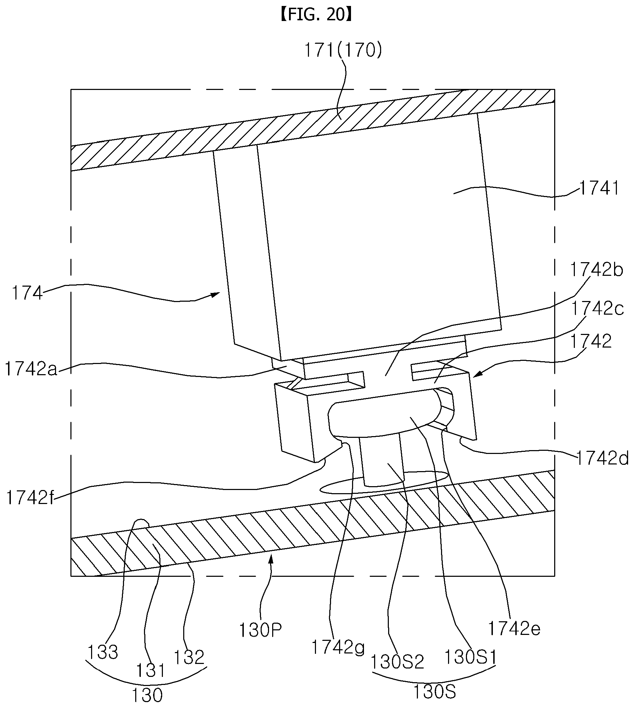

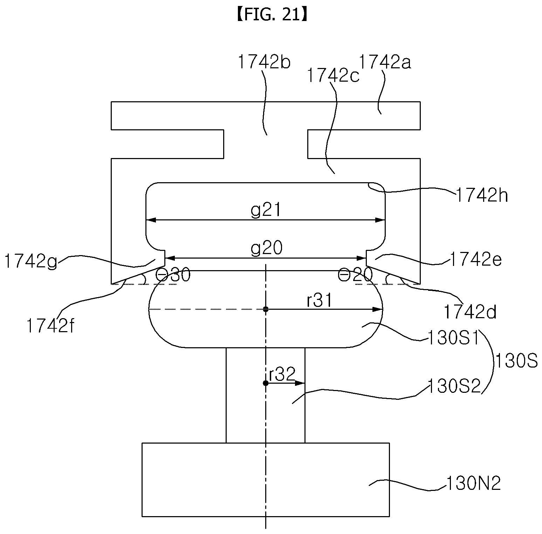

Referring to FIGS. 20 and 21, a side pin 130S may protrude from the rear surface of the material complexed panel 130 to the rear. For example, the side pin 130S may be a pem nut provided in a portion 130N2 of the material complexed panel 130.

The side pin 130S may include a head 130S1 and a body 130S2. The body 130S2 may connect the material complexed panel 130 and the head 130S1. The radius r21 of the head may be larger than the radius r32 of the body 130S2. In other words, an undercut may be formed between the head 130S1 and the body 130S2. Also, the periphery of the head 130S1 may be round-shaped.

Some of a plurality of side pins 130S may be adjacent to the inner side of a first side part 172c (refer to FIG. 12). The remainder of the plurality of side pins 130S may be adjacent to the inner side of the second side part 172d of the back cover 170 (refer to FIG. 12).

A holder 174 may protrude forward from the inner side of the rear part 171 of the back cover 170. The holder 174 may be aligned with the side pin 130S. Some of a plurality of holders 174 may be aligned with side pins 130S adjacent to the inner side of the first side part 172c. The remainder of the plurality of holders 174 may be aligned with the side pins 130S adjacent to the inner side of the second side part 172d.

The holder 174 may include a protruding portion 1741 and a grab 1742. The protruding portion 1741 may protrude forward from the inner side of the rear part 171. The grab 1742 may be located between the protruding portion 1741 and the side pin 130S and may be fixed to the protruding portion 1741.

The grab 1742 may include a first part 1742a, a second part 1742b, and a third part 1742c. The first part 1742a may be fixed to the front end of the protruding portion 1741. The third part 1742c may be located in front of the first part 1742c, and the second part 1742b may connect the first part 1742a and the third part 1742c. Also, ribs (symbols unassigned) may connect the first part 1742a and the third part 1742c. The third part 1742c may be elastic.

A receiving portion 1742h may be formed by being depressed to the rear from the front end of the third part 1742c. The first portion 1742d of the third part 1742c may oppose the second portion 1742f of the third part 1742c relative to the receiving portion 1742h, and the first portion 1742d and the second portion 1742f may form the front end of the third part 1742.

The front end of the first portion 1742d may form a second angle *θ*₂₀ theta 20 relative to a virtual line parallel to the width direction of the receiving portion 1742h. The front end of the second portion 1742f may form a third angle *θ*₃₀ relative to a virtual line parallel to the width direction of the receiving portion 1742h. For example, the second angle *θ*₂₀ and the third angle *θ*₃₀ may be the same. The gap between the front end of the first portion 1742d and the front end of the second portion 1742f may gradually increase in the direction from the rear to the front. The first part 1742d and the second part 1742f may be referred to as a chamfer.

The first protrusion 1742e may protrude from the inner side of the first portion 1742d toward the second portion 1742f. The second protrusion 1742g may protrude from the inner side of the second portion 1742f toward the first protrusion 1742e. The receiving portion 1742h may be located at the rear of the first protrusion 1742e and the second protrusion 1742g and may have a square bracket shape as a whole. The gap g20 between the first protrusion 1742e and the second protrusion 1742g may be smaller than the width g21 of the receiving portion 1742h. In other words, an undercut may be formed between the protrusion 1742e, 1742g and the receiving portion 1742h.

In response to the movement of the back cover 170 and the holder 174 toward the side pin 130S, the side pin 130S may be easily inserted into the receiving portion 1742h of the grab 1742 along the front end of the third part 1742c. In addition, as the periphery of the head 130S1 is round-shaped, the side pin 130S may be more easily inserted into the receiving portion 1742h.

At this time, the gap g20 between the first protrusion 1742e and the second protrusion 1742g may be widened by the head 130S1 and may be narrowed again when the head 130S1 is inserted into the receiving portion 1742h. The first protrusion 1742e and the second protrusion 1742g may be hung on the head 130S1 inserted into the receiving portion 1742h. In other words, the radius r31 of the head 130S1 may be larger than the gap g20 between the first protrusion 1742e and the second protrusion 1742g and may be equal to or less than the width g21 of the receiving portion 1742h.

Accordingly, the back cover 170 may be coupled with the material complexed panel 130 through the holder 174. In other words, the back cover 170 may be coupled with the material complexed panel 130 without involving the PCB plate 150 (refer to FIGS. 10 and 11).

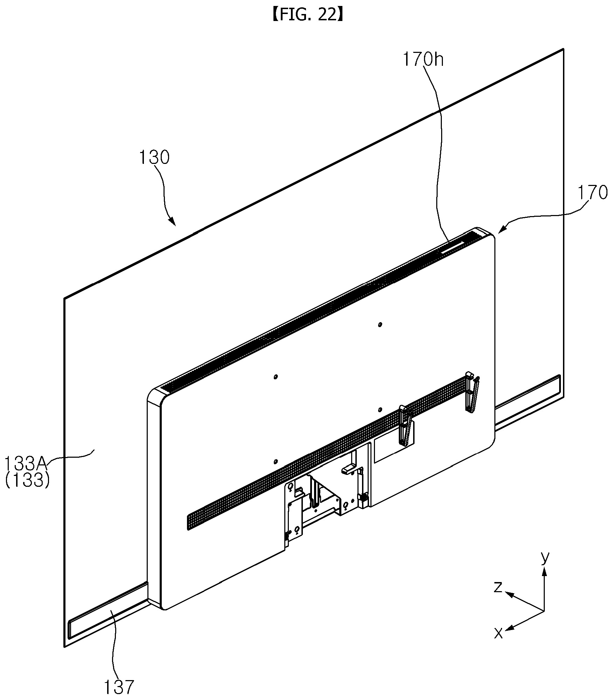

Referring to FIG. 22, the back cover 170 may be smaller than the size of the material complexed panel 130. In this case, a portion 133A of the rear skin 133 of the material complexed panel 130 may not be covered by the back cover 170. Alternatively, the size of the back cover 170 may correspond to the size of the material complexed panel 130. For example, the back cover 170 may include a metallic or plastic material.

Meanwhile, a plurality of holes 170h through which air passes may be formed at the upper edge of the back cover 170.

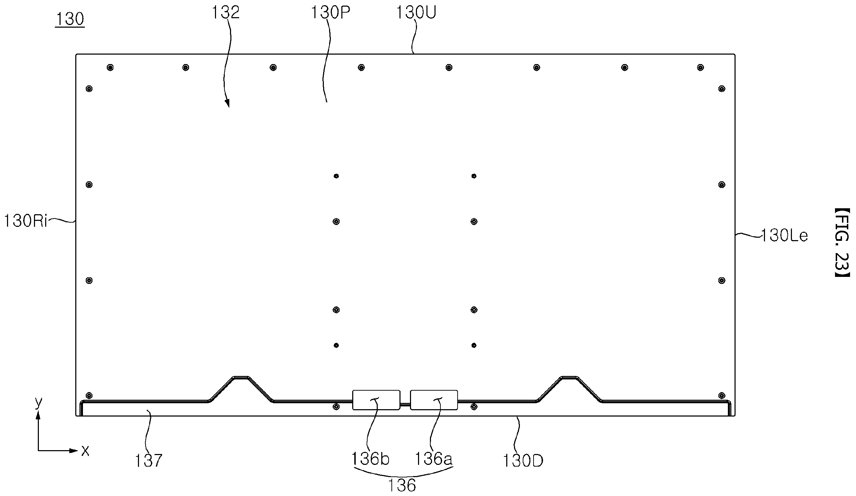

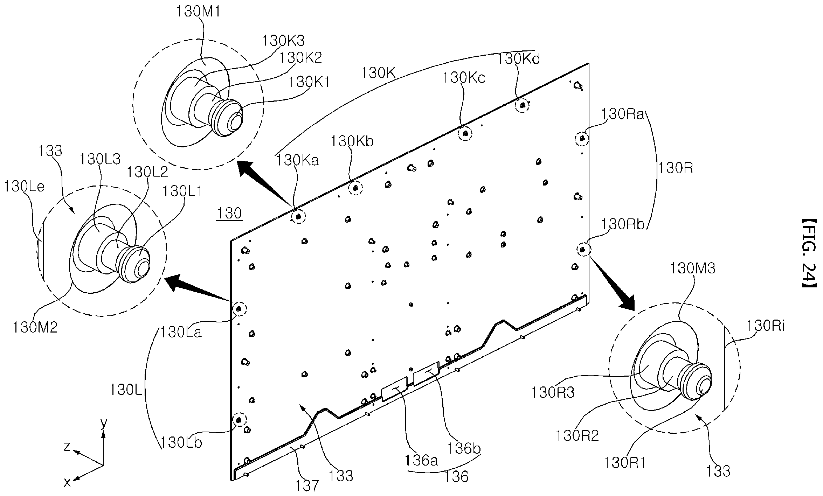

Referring to FIGS. 23 and 24, the material complexed panel 130 may include a flat portion 130P and a receiving portion 137. The front skin 132 of the material complexed panel 130 may define the respective front surfaces of the flat portion 130P and the receiving portion 137.

The receiving portion 137 may be formed by being pressed to the rear from the flat portion 130P. The receiving portion 137 may be adjacent to the lower edge of the material complexed panel 130. The receiving portion 137 may form a step for the flat portion 130P. A source PCB (S-PCB) (not shown in the figure) may be located in the receiving portion 137.

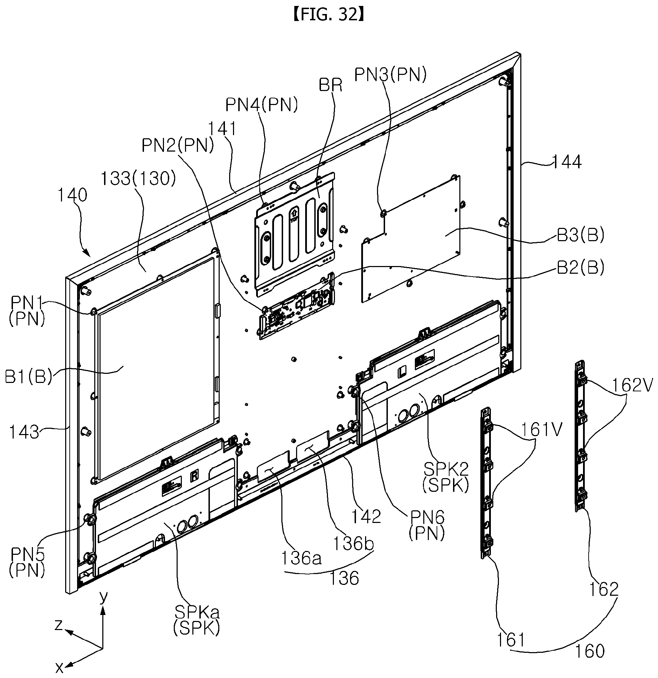

The cable hole 136 may be formed through the receiving portion 137. For example, a plurality of cable holes 136a, 136b may be formed close to each other. A cable (not shown in the figure) may be electrically connected to the S-PCB 115 and electrically connected to the T-CON board B2 (refer to FIG. 32) through the cable hole 136.

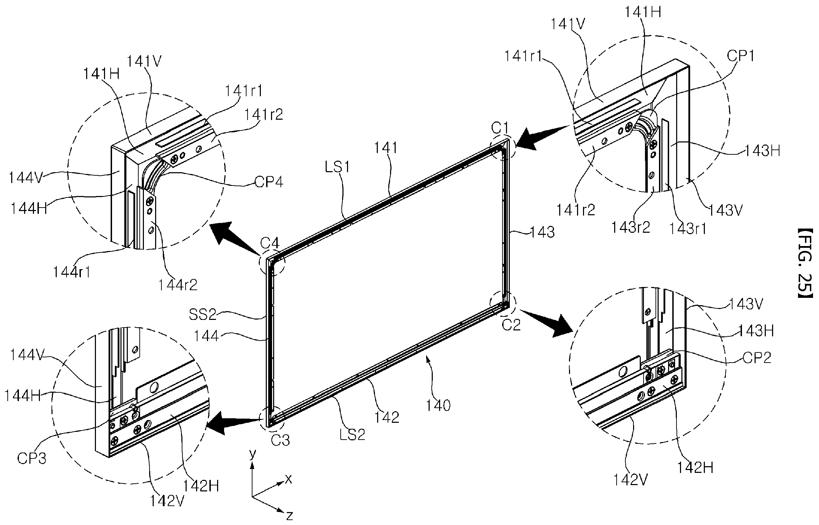

Referring to FIG. 25, a side frame 140 may include a first part 141, a second part 142, a third part 143, and a fourth part 144. The side frame 140 may be referred to as a guide panel or a middle cabinet.

The first vertical portion 141V of the first part 141 may form an upper edge of the side frame 140. The first horizontal portion 141H may intersect the first vertical portion 141V, and the first rib 141r1, 141r2 may extend along the first vertical portion 141V on the first horizontal portion 141H.

The second vertical portion 142V of the second part 142 may form a lower edge of the side frame 140. The second horizontal portion 142H may intersect the second vertical portion 142V.

The third vertical portion 143V of the third part 143 may form a left edge of the side frame 140. The third horizontal portion 143H may intersect the third vertical portion 143V, and the third rib 143r1, 143r2 may extend along the third vertical portion 143V on the third horizontal portion 143H.

Also, the first connecting member CP1 may connect the left end of the first rib 141r2 with the upper end of the third rib 143r2. The second connecting member CP2 may connect the left end of the second horizontal portion 142H with the lower end of the third horizontal portion 143H. Accordingly, the third part 143 may be coupled with the first part 141 and the second part 142.

The fourth vertical portion 144V of the fourth part 144 may form a right edge of the side frame 140. The fourth horizontal portion 144H may intersect the fourth vertical portion 144V, and the fourth rib 144r1, 144r2 may extend along the fourth vertical portion 144V on the fourth horizontal portion 144H.

Also, the third connecting member CP3 may connect the right end of the second horizontal portion 142H with the lower end of the fourth horizontal portion 144H. The fourth connecting member CP4 may connect the right end of the first rib 141r2 and the upper end of the fourth rib 144r2. Accordingly, the fourth part 144 may be coupled with the first part 141 and the second part 142.

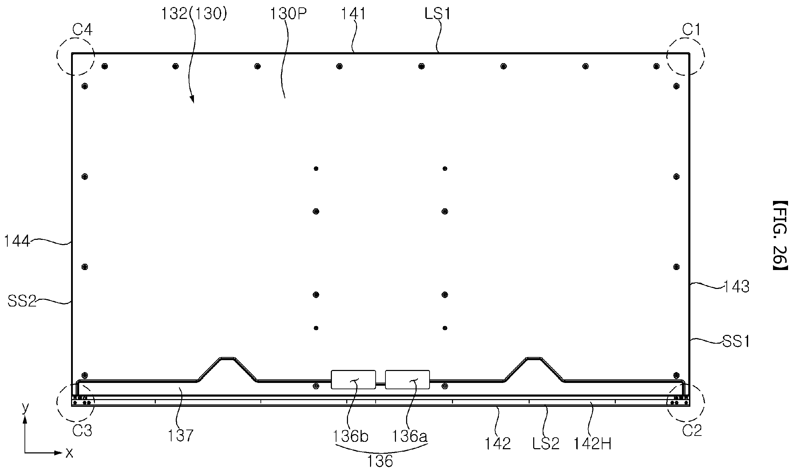

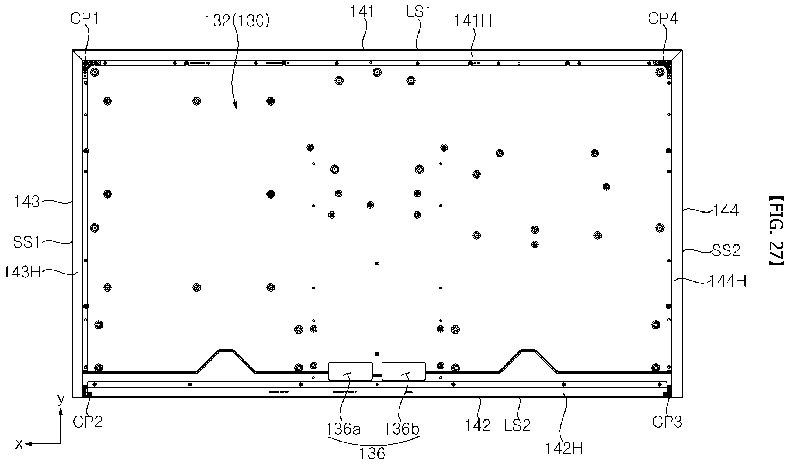

Referring to FIGS. 26 and 27, the material complexed panel 130 may be located at the front of the side frame 140 and may be coupled with the side frame 140. The material complexed panel 130 may cover the front of the ribs 141r1, 141r2, 143r1, 143r2, 144r1, 144r2 described above.

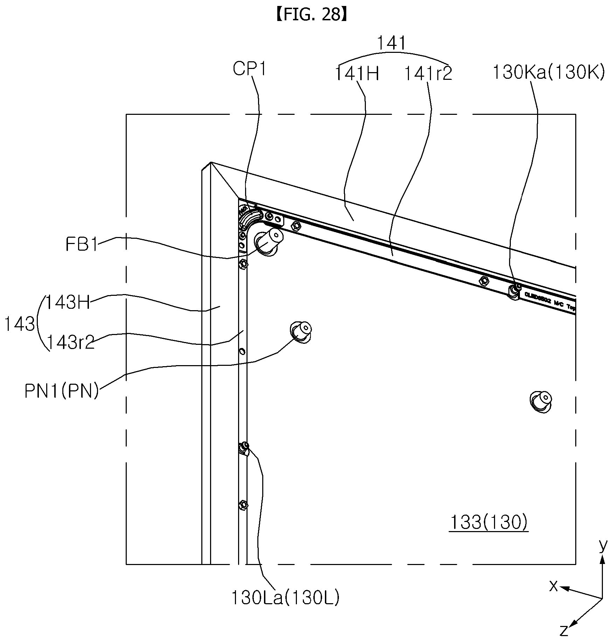

Referring to FIG. 28, the first corner fixing portion FB1 may protrude to the rear from the rear skin 133 of the material complexed panel 130 and may be adjacent to the first connecting member CP1.

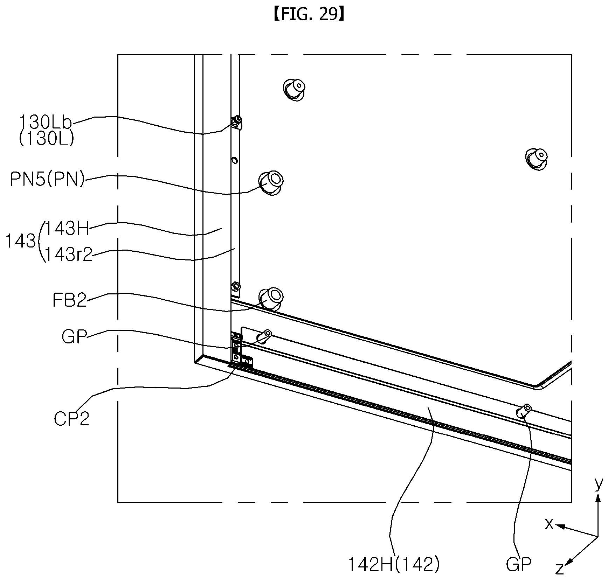

Referring to FIG. 29, the second corner fixing portion FB2 may protrude to the rear from the rear skin 133 of the material complexed panel 130 and may be adjacent to the second connecting member CP2.

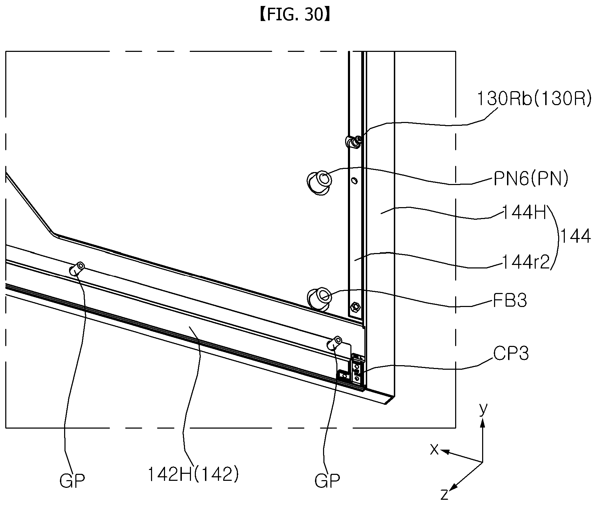

Referring to FIG. 30, the third corner fixing portion FB3 may protrude to the rear from the rear skin 133 of the material complexed panel 130 and may be adjacent to the third connecting member CP3.

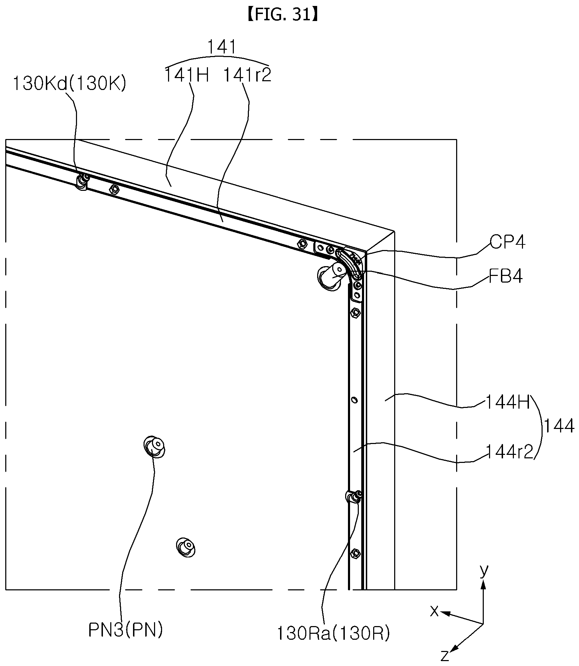

Referring to FIG. 31, the fourth corner fixing portion FB4 may protrude to the rear from the rear skin 133 of the material complexed panel 130 and may be adjacent to the fourth connecting member CP4.

Meanwhile, the pins 130K, 130L, 130R described below may penetrate the ribs 141r2, 143r2, 144r2.

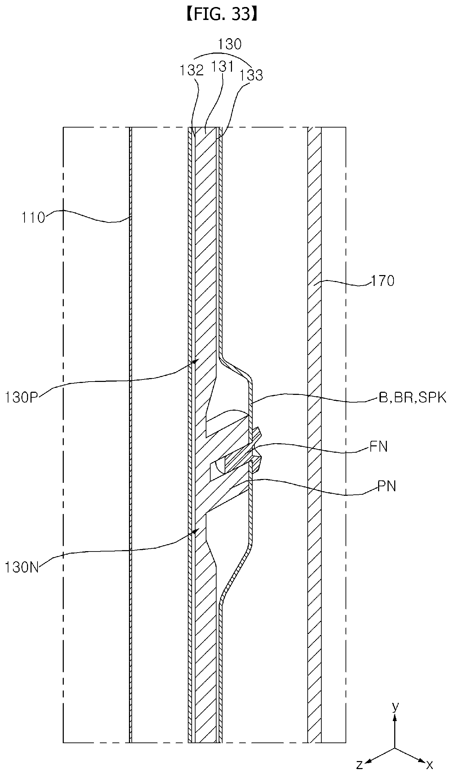

Referring to FIGS. 32 and 33, a plurality of components B, BR, SPK may be mounted on the rear skin 133 of the material complexed panel 130.

A printed circuit board (PCB) B may be located at the rear of the material complexed panel 130. For example, a plurality of PCBs B1, B2, B3 may be spaced apart from each other. A power supply board B1 may provide power to each configuration of the display device. A timing controller (T-CON) board B2 may provide a video signal to the display panel 110. A main board B3 may control each configuration of the display device.

A fixing plate BR may be located at the rear of the material complexed panel 130. The fixing plate BR may be located between the first part 141 of the side frame 140 and the T-CON board B2.

A speaker SPK may be located at the rear of the material complexed panel 130. The first speaker SPKa may be adjacent to the second part 142 and the third part 143 of the side frame 140. The second speaker SPKb may be adjacent to the second part 142 and the fourth part 144 of the side frame 140.

A fixing portion PN may protrude from the rear skin 133 of the material complexed panel 130 to the rear. For example, the depression portion 130N may be formed by being depressed from the rear skin 133 to the front, and the fixing portion PN may protrude to the rear from the depression portion 130N. For example, the fixing portion PN may be a pem nut. A fastening member FN such as a screw may be fastened to the fixing portion PN through the PCB B, the fixing plate BR, or the speaker SPK.

Accordingly, the PCB B, the fixing plate BR, and the speaker SPK may be coupled with the material complexed panel 130. In other words, the PCB B, the fixing plate BR, and the speaker SPK may be coupled with the material complexed panel 130 without involving the PCB plate 150 (refer to FIGS. 10 and 11).

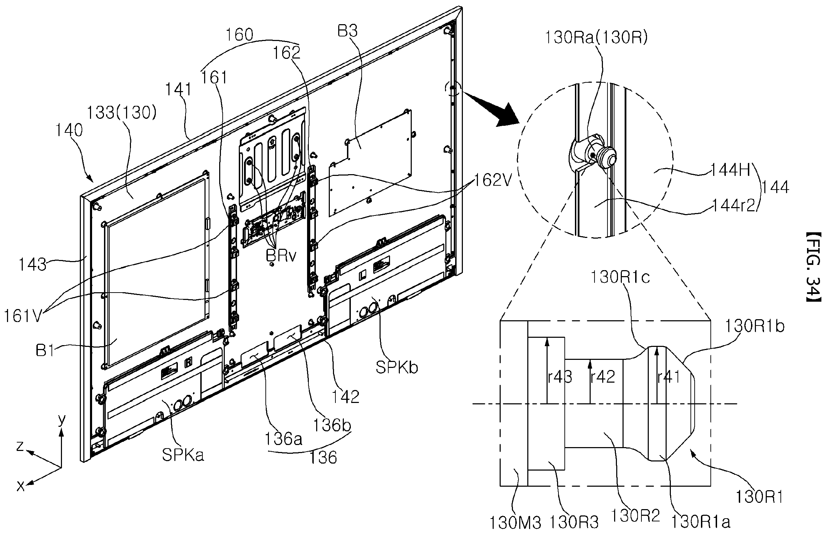

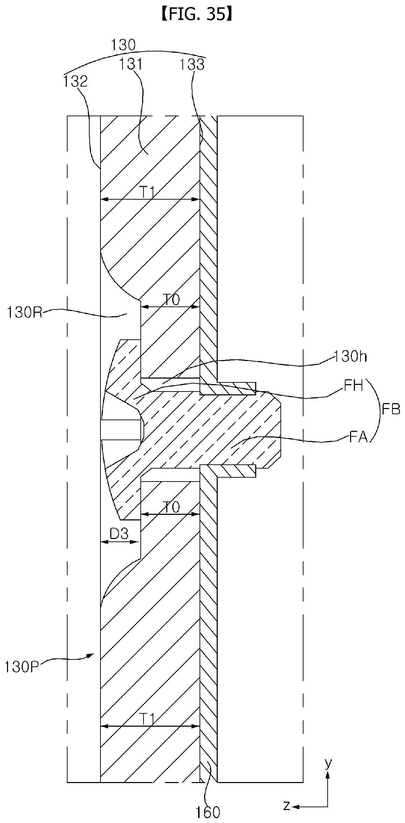

Referring to FIGS. 34 and 35, a vertical bar 160 may be extended in the vertical direction. The vertical bar 160 may be located at the rear of the material complexed panel 130. The first vertical bar 161 and the second vertical bar 162 may be separated from each other in the horizontal direction. The first vertical bar 161 and the second vertical bar 162 may have the same shape.

The body FA of a fastening member FB may penetrate the depression portion 130R, and the head FH of the fastening member FB may be hung on the front surface of the depression portion 130R. Here, the depression portion 130R may be formed by being depressed to the rear from the flat portion 130P. The body FA of the fastening member FB may be screwed into the vertical bar 160.

Accordingly, the first vertical bar 161 and the second vertical bar 162 may be coupled with the material complexed plate 130.

Referring back to FIGS. 24 and 34, the top pin 130K, the first side pin 130L, and the second side pin 130R may protrude to the rear from the rear skin 133 of the material complexed panel 130. For example, the pins 130K, 130L, 130R may be pem nuts provided in the depression portions 130M1, 130M2, 130M3 formed in the rear skin 133.

The top pin 130K may be adjacent to the upper edge of the material complexed panel 130. For example, a plurality of top pins 130Ka, 130Kb, 130Kc, and 130Kd may be spaced apart from each other along the upper edge of the material complexed panel 130.

The first side pin 130L may be adjacent to the left edge of the material complexed panel 130. For example, a plurality of first side pins 130La, 130Lb may be spaced apart from each other along the left edge of the material complexed panel 130.

The second side pin 130R may be adjacent to the right edge of the material complexed panel 130. For example, a plurality of second side pins 130Ra, 130Rb may be spaced apart from each other along the right edge of the material complexed panel 130.

Also, the second side pin 130R may include a head 130R1, a body 130R2, and a leg 130R3. The body 130R2 and the leg 130R3 may connect the depression portion 130M3 and the head 130R1. The radius r41 of the head 130R1 may be larger than the radius r42 of the body 130R2 and may be equal to or smaller than the radius r43 of the leg 130R3.

Also, the head 130R1 may include a central portion 130R1a, a rear portion 130R1b, and a front portion 130R1c. The central portion 130R1a may form a maximum radius r41 of the head 130R1. The rear portion 130R1b may be connected to the rear of the central portion 130R1a and may have a radius that gradually becomes smaller as distance from the central portion 130R1a gets larger. The front portion 130R1c may be connected to the front of the central portion 130R1a and may have a radius that gradually becomes smaller as distance from the central portion 130R1a gets larger. The rear portion 130R1b may be referred to as a chamfer, and the front portion 130R1c may be referred to as an undercut.

For example, the top pin 130K and the first side pin 130L may have the same shape as the second side pin 130R. In this case, the foregoing descriptions of the second side pin 130R may be applied the same manner to the top pin 130K and the first side pin 130L. In other words, the shapes of the head 130K1, the body 130K2, and the leg 130K3 of the top pin 130K may be the same as the shape of the head 130R1, the body 130R2, and the leg 130R3 of the second side pin 130R. Also, the shapes of the head 130L1, the body 130L2, and the leg 130L3 of the first side pin 130L may be the same as the shapes of the head 130R1, the body 130R2, and the leg 130R3 of the second side pin 130R.

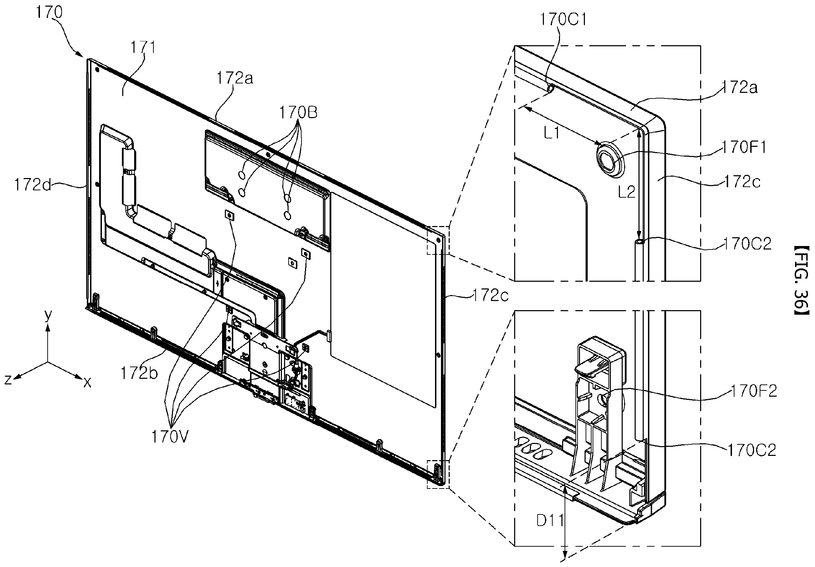

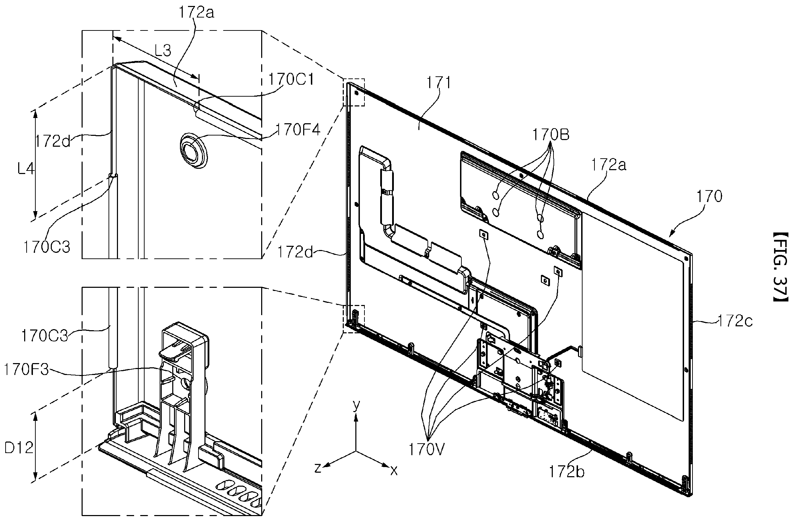

Referring to FIGS. 36 and 37, the rear part 171 may form a rear surface of the back cover 170. The top part 172a may extend along the upper edge of the rear part 171 and may intersect the rear part 171. The bottom part 172b may extend along the lower edge of the rear part 171 and may intersect the rear part 171. The first side part 172c may extend along the left edge of the rear part 171 and may intersect the rear part 171. The second side part 172d may extend along the right edge of the rear part 171 and may intersect the rear part 171.

The first corner fixing hole 170F1 may be formed through the rear part 171 and may be adjacent to the top part 172a and the first side part 172c.

The second corner fixing hole 170F2 may be formed through the rear part 171 and may be adjacent to the bottom part 172b and the first side part 172c.

The third corner fixing hole 170F3 may be formed through the rear part 171 and may be adjacent to the bottom part 172b and the second side part 172d.

The fourth corner fixing hole 170F4 may be formed through the rear part 171 and may be adjacent to the top part 172a and the second side part 172d.

The top hanging portion 170C1 may be formed by being curled to the rear from the front end of the top part 172a. The top hanging portion 170C1 may extend along the top part 172a. The left end of the top hanging portion 170C1 may be spaced apart to the right from the first side part 172c (refer to L1 of FIG. 36). The right end of the top hanging portion 170C1 may be spaced apart from the second side part 172d to the left (refer to L3 of FIG. 37).

The first side hanging portion 170C2 may be formed by being curled to the rear from the front end of the first side part 172c. The first side hanging portion 170C2 may be extended along the first side part 172c. The upper end of the first side hanging portion 170C2 may be spaced apart from the top part 172a toward the lower side (refer to L2 in FIG. 36). The lower end of the first side hanging portion 170C2 may be spaced apart from the bottom part 172b toward the upper side (refer to D11 in FIG. 36).

The second side hanging portion 170C3 may be formed by being curled to the rear from the front end of the second side part 172d. The second side hanging portion 170C3 may be extended along the second side part 172d. The upper end of the second side hanging portion 170C3 may be spaced apart from the top part 172a toward the lower side (refer to L4 in FIG. 37). The lower end of the second side hanging portion 170C3 may be spaced apart from the bottom part 172b toward the upper side (refer to D12 in FIG. 37).

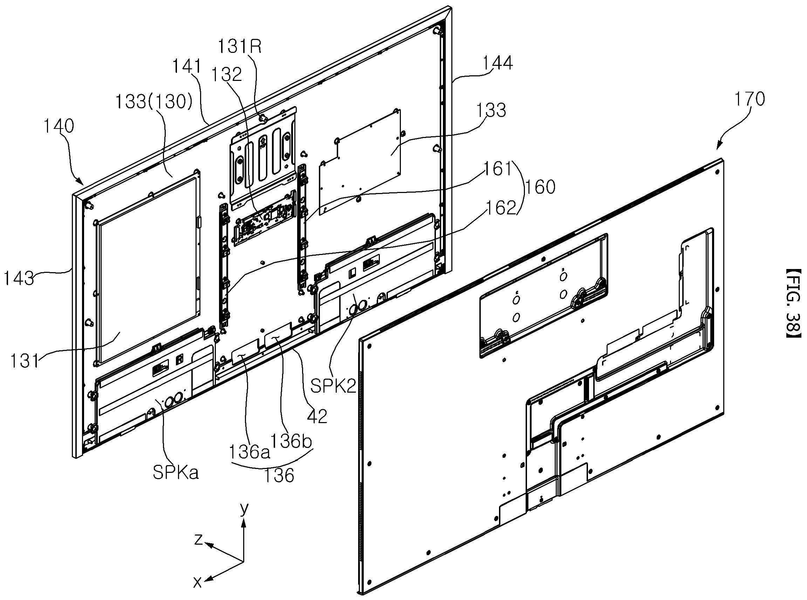

Referring to FIGS. 38 to 41, the back cover 170 may get close to the rear of the material complexed panel 130.

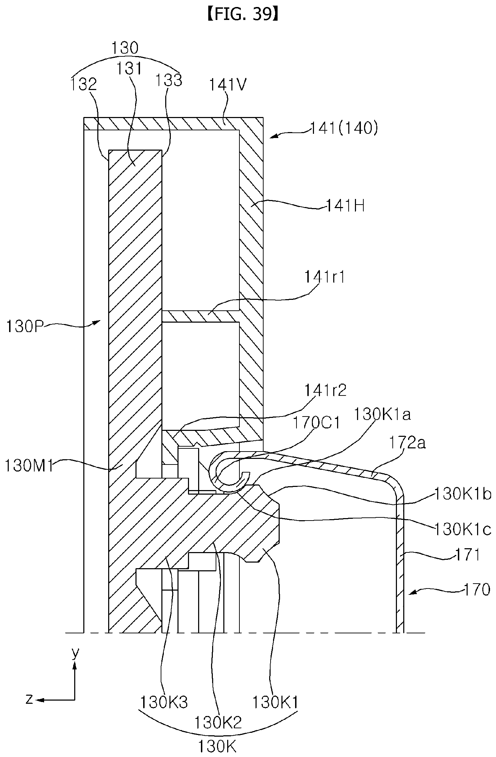

Referring to FIG. 39, the top hanging portion 170C1 may be inserted between the first rib 141r2 and the top pin 130K. At this time, as the top hanging portion 170C1 moves along the rear portion 130K1b of the head 130K1 of the top pin 130K, the top part 172a may be raised up relative to the rear part 171. Also, the top hanging portion 170C1 may pass through the central portion 130K1a of the head 130K1 and may be hung on the front portion 130K1c.

Meanwhile, the first vertical portion 141V may cover the upper edge of the material complexed panel 130, and the first rib 141r1, 141r2 may support the rear skin 133 of the material complexed panel 130.

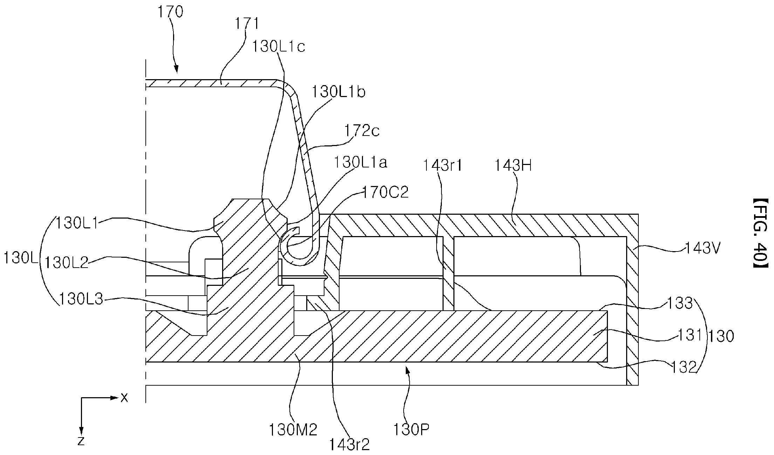

Referring to FIG. 40, the first side hanging portion 170C2 may be inserted between the third rib 143r2 and the first side pin 130L. At this time, as the first side hanging portion 170C2 moves along the rear portion 130L1b of the head 130L1 of the first side pin 130L, the first side part 172c may diverge to the left relative to the rear part 171. In addition, the first side hanging portion 170C2 may pass through the central portion 130L1a of the head 130L1 and may be hung on the front portion 130L1c.

Meanwhile, the third vertical portion 143V may cover the left edge of the material complexed panel 130, and the third rib 143 r1, 143r2 may support the rear skin 133 of the material complexed panel 130.

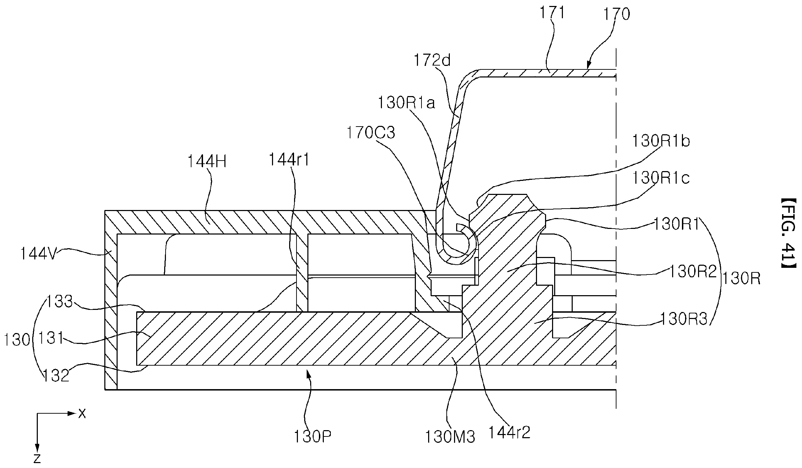

Referring to FIG. 41, the second side hanging portion 170C3 may be inserted between the fourth rib 144r2 and the second side pin 130R. At this time, as the second side hanging portion 170C3 moves along the rear portion 130R1b of the head 130R1 of the second side pin 130R, the second side part 172d may diverge to the right relative to the rear part 171. Also, the second side hanging portion 170C3 may pass through the central portion 130R1a of the head 130R1 and may be hung on the front portion 130R1c.

Meanwhile, the fourth vertical portion 144V may cover the right edge of the material complexed panel 130, and the fourth rib 144r1, 144r2 may support the rear skin 133 of the material complexed panel 130.

Accordingly, the top part 172a may be coupled with the material complexed panel 130 through the top hanging portion 170C1. In other words, the back cover 170 may be coupled with the material complexed panel 130 without involving the PCB plate 150 (refer to FIGS. 10 and 11).

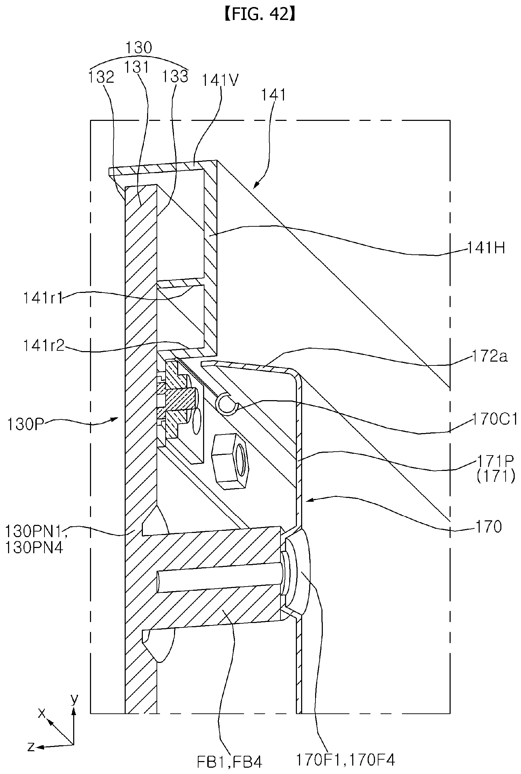

Referring to FIGS. 42 to 44, the first corner fixing hole 170F1 may be aligned with a first corner fixing portion FB1, and the second corner fixing hole 170F2 may be aligned with the second corner fixing portion FB2. The third corner fixing hole 170F3 may be aligned with the third corner fixing portion FB3, and the fourth corner fixing hole 170F4 may be aligned with the fourth corner fixing portion FB4. For example, the corner fixing portions FB1, FB2, FB3, FB4 may be pem nuts. In other words, a fastening member, such as a screw, may pass the corner fixing holes 170F1, 170F2, 170F3, 170F4 and may be fastened with the corner fixing portions FB1, FB2, FB3, FB4.

Accordingly, the back cover 170 may be coupled with the material complexed panel 130. In other words, the back cover 170 may be coupled with the material complexed panel 130 without involving the PCB plate 150 (refer to FIGS. 10 and 11).

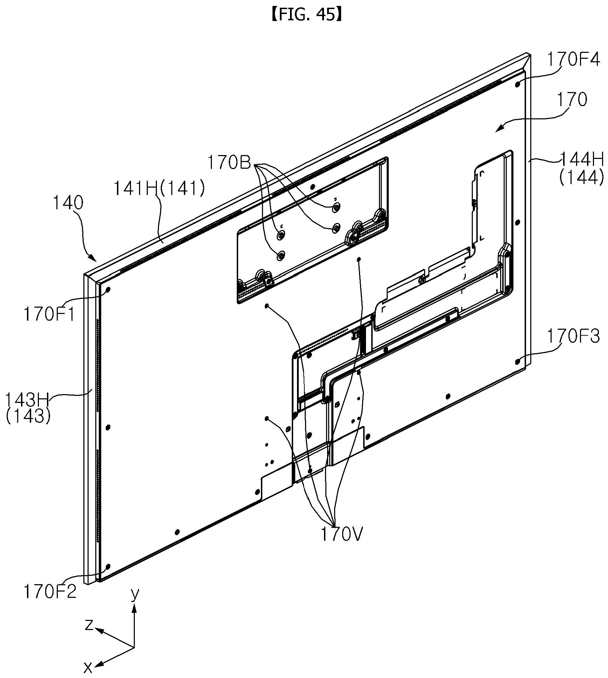

Referring to FIGS. 35 and 45, the fastening members 161v, 162v may be formed in the vertical bar 161, 162 and may be aligned with the fastening holes 170v formed on the back cover 170. The spacing between the fastening holes 170v may conform to the Video Electronics Standards Association (VESA) specifications.

The fixing portions BRv may be formed on the fixing plate BR and may be aligned with the fixing holes 170B formed on the back cover 170.

Accordingly, stands or brackets for the display device may be screwed to the fastening portions 161v, 162v or fixing portions BRv through the fastening holes 170v or fixing holes 170B.

Meanwhile, the back cover 170 may correspond to the size of the metal complexed panel 130 (refer to FIG. 38). In this case, the rear of the metal complexed panel 130 may be covered by the back cover 170. Alternatively, the size of the back cover 170 may be smaller than the size of the metal complexed panel 130. For example, the back cover 170 may include a metallic or plastic material.

Meanwhile, a plurality of holes (symbols unassigned) through which air passes may be formed on the upper edge of the back cover 170.

Referring to FIGS. 1 to 45, a display device according to one aspect of the present disclosure may include a display panel; a frame positioned behind the display panel and to which the display panel is coupled; and a back cover covering a rear of the frame, wherein the frame may include a body protruding from a rear surface of the frame toward an inner side of the back cover and a head protruding from a side surface of the body toward an outer side of the body, and a portion of the back cover may be located between the rear surface of the frame and the head and may be hung on the head.

The frame may include a front skin forming a front surface of the frame; a rear skin forming the rear surface of the frame; and a core located between the front skin and the rear skin and having fibers.

The pin may be adjacent to one side of the back cover.

The pin may include a plurality of pins spaced apart from each other along the one side of the back cover.

The pin may include a top pin adjacent to the upper side of the back cover and including the body and the head; and a side pin adjacent to at least one of the left or right side of the back cover and including the body and the head.

The back cover may include a rear part forming the rear surface of the back cover; a top part bent to the front from the upper side of the rear part; and a hanging portion protruding toward the top pin from an inner side of the top part and being hung on the top pin.

The hanging portion may further include a block intersecting the top part; and a groove formed toward an inner side of the block from the lower side of the block, and to which the body of the top pin is inserted, wherein the block may be located between the rear surface of the frame and the head of the top pin and may be hung on the head of the top pin.

The block may further include a first guide surface; a second guide surface which is opposite the first guide surface with respect to the groove and defining a lower portion of a boundary of the groove together with the first guide surface; and a seating surface connecting the first guide surface and the second guide surface and defining an upper portion of the boundary of the groove, wherein a gap between the first guide surface and the second guide surface may gradually increase from top to bottom of the groove, a periphery of the head of the top pin may be round-shaped, and the seating surface may be an upwardly convex curved surface and may be seated on the body of the top pin.

The back cover may include a rear part forming a rear surface of the back cover; and a holder protruding toward the side pin from an inner side of the rear part and being hung on the side pin.

The holder may further include a first portion adjacent to the periphery of the head of the side pin; a second portion which is opposite the first portion with respect to the head of the side pin; a receiving portion located between the first portion and the second portion and to which the head of the side pin is inserted; a first protrusion formed inside the first portion and hung on the head of the side pin; and a second protrusion formed inside the second portion and hung on the head of the side pin.

The front ends of the first portion and the second portion may be formed to be inclined toward the first protrusion and the second protrusion, respectively, and a periphery of the head of the side pin may be round-shaped.

The back cover may include a rear part forming a rear surface of the back cover; a top part bent to the front from the upper side of the rear part; and a top hanging portion being curled to a rear from a front end of the top part, wherein the top hanging portion may be located between the rear surface of the frame and the head of the top pin and may be hung on the head of the top pin.

The back cover may include a rear part forming a rear surface of the back cover; a side part bent to the front from the left side or the right side of the rear part; and a side hanging portion being curled to the rear from a front end of the side part, wherein the side hanging portion may be located between the rear surface of the frame and the head of the side pin and may be hung on the head of the side pin.

The head of the side pin may further include a central portion forming a maximum radius of the head of the side pin; a rear portion being connected to a rear of the central portion and having a radius that gradually becomes smaller as distance from the central portion gets larger; and a front portion being connected to a front of the central portion and having a radius that gradually becomes smaller as distance from the central portion gets larger, wherein the side hanging portion may be hung on the front portion.

The display device may further include a PCB located between the frame and the back cover, wherein the frame may further include a fixing portion protruding to the rear from the rear surface of the frame, to which the PCB is coupled.

Particular embodiments or other embodiments of the present disclosure described above are not mutually exclusive to each other or distinguishable from each other. Individual structures or functions of particular embodiments or other embodiments of the present disclosure described above may be used in parallel therewith or in combination thereof.

For example, it means that structure A described with reference to a specific embodiment and/or figure and structure B described with reference to another embodiment and/or figure may be coupled together. In other words, even if a combination of two different structures is not explicitly indicated, it should be understood that combination thereof is possible unless otherwise stated as impossible.

The detailed descriptions above should be regarded as being illustrative rather than restrictive in every aspect. The technical scope of the present disclosure should be determined by a reasonable interpretation of the appended claims, and all of the modifications that fall within an equivalent scope of the present disclosure belong to the technical scope of the present disclosure.

## Claims

1. A display device comprising:
a display panel;
a frame positioned behind the display panel and to which the display panel is coupled; and
a back cover covering a rear of the frame,
wherein the frame comprises:
a pin including a body protruding from a rear surface of the frame toward an inner side of the back cover and a head protruding from a side surface of the body toward an outer side of the body, and
a portion of the back cover is located between the rear surface of the frame and the head and is hung on the head.

2. The display device of claim 1, wherein the frame comprises:
a front skin forming a front surface of the frame;
a rear skin forming the rear surface of the frame; and
a core located between the front skin and the rear skin and having fibers.

3. The display device of claim 1, wherein the pin is adjacent to one side of the back cover.

4. The display device of claim 3, wherein the pin comprises a plurality of pins spaced apart from each other along the one side of the back cover.

5. The display device of claim 3, wherein the pin comprises:
a top pin adjacent to an upper side of the back cover and including the body and the head; and
a side pin adjacent to at least one of a left side or a right side of the back cover and including the body and the head.

6. The display device of claim 5, wherein the back cover comprises:
a rear part forming a rear surface of the back cover;
a top part bent to the front from an upper side of the rear part; and
a hanging portion protruding toward the top pin from an inner side of the top part and being hung on the top pin.

7. The display device of claim 6, wherein the hanging portion further comprises:
a block intersecting the top part; and
a groove formed toward an inner side of the block from a lower side of the block, and to which the body of the top pin is inserted,
wherein the block is located between the rear surface of the frame and the head of the top pin and is hung on the head of the top pin.

8. The display device of claim 7, wherein the block further comprises:
a first guide surface;
a second guide surface which is opposite the first guide surface with respect to the groove and defining a lower portion of a boundary of the groove together with the first guide surface; and
a seating surface connecting the first guide surface and the second guide surface and defining an upper portion of the boundary of the groove,
wherein a gap between the first guide surface and the second guide surface gradually increases from top to bottom of the groove,
a periphery of the head of the top pin is round-shaped, and
the seating surface is an upwardly convex curved surface and is seated on the body of the top pin.

9. The display device of claim 5, wherein the back cover comprises:
a rear part forming a rear surface of the back cover; and
a holder protruding toward the side pin from an inner side of the rear part and being hung on the side pin.

10. The display device of claim 9, wherein the holder further comprises:
a first portion adjacent to the periphery of the head of the side pin;
a second portion which is opposite the first portion with respect to the head of the side pin;
a receiving portion located between the first portion and the second portion and to which the head of the side pin is inserted;
a first protrusion formed inside the first portion and hung on the head of the side pin; and
a second protrusion formed inside the second portion and hung on the head of the side pin.

11. The display device of claim 10, wherein front ends of the first portion and the second portion are formed to be inclined toward the first protrusion and the second protrusion, respectively, and
a periphery of the head of the side pin is round-shaped.

12. The display device of claim 5, wherein the back cover comprises:
a rear part forming a rear surface of the back cover;
a top part bent to the front from an upper side of the rear part; and
a top hanging portion being curled to a rear from a front end of the top part,
wherein the top hanging portion is located between the rear surface of the frame and the head of the top pin and is hung on the head of the top pin.

13. The display device of claim 5, wherein the back cover comprises:
a rear part forming a rear surface of the back cover;
a side part bent to the front from a left side or a right side of the rear part; and
a side hanging portion being curled to the rear from a front end of the side part,
wherein the side hanging portion is located between the rear surface of the frame and the head of the side pin and is hung on the head of the side pin.

14. The display device of claim 13, wherein the head of the side pin further comprises:
a central portion forming a maximum radius of the head of the side pin;
a rear portion being connected to a rear of the central portion and having a radius that gradually becomes smaller as distance from the central portion gets larger; and
a front portion being connected to a front of the central portion and having a radius that gradually becomes smaller as distance from the central portion gets larger,
wherein the side hanging portion is hung on the front portion.

15. The display device of claim 1, further comprising a PCB located between the frame and the back cover,
wherein the frame further comprises a fixing portion protruding to the rear from a rear surface of the frame, to which the PCB is coupled.
